# DEMANDE DE BREVET EUROPEEN

(11) **EP 4 071 268 A1**
(43) Date de publication de la demande: **12.10.2022**
(21) Numéro de dépôt: 21167303.3
(22) Date de dépôt: 08.04.2021
(51) Int. Cl.: C23C 14/48, C23C 14/58, G04B 37/00, G04B 45/00, B44C 1/00, B44C 1/22, C23C 14/00, G04D 3/00

(54) **PROCÉDÉ DE COLORATION D'UN MÉTAL ET METAL COLORÉ**

(71) Demandeur: Comadur S.A., 2400 Le Locle (CH)
(72) Inventeur: VUILLE, Pierry, 2338 Les Emibois (CH); MEIER, Julien, 2068 Hauterive (CH); BOULMAY, Alexis, 25500 Morteau (FR)
(74) Mandataire: ICB SA

(57) **Abrégé**

La présente invention concerne un procédé de coloration d'une pièce à traiter (20) réalisée en métal, ce procédé comprenant l'étape qui consiste à implanter des ions mono- ou multichargés dans une couche superficielle de la pièce à traiter (20) en dirigeant vers cette pièce à traiter (20) un faisceau d'ions mono- ou multichargés produit par une source d'ions mono- ou multichargés, la pièce à traiter (20) changeant de couleur sous l'effet de cette implantation ionique.

L'invention concerne également un métal coloré pouvant notamment être obtenu au moyen du procédé ci-dessus.

## Description

### Domaine technique de l'invention

La présente invention concerne un procédé de coloration d'une pièce métallique, notamment une pièce métallique incrustée dans un matériau céramique. La présente invention concerne également une pièce métallique colorée obtenue grâce à ce procédé de coloration.

### Arrière-plan technologique

De nombreux procédés de coloration de métaux sont déjà connus dans l'état de la technique. L'un de ces procédés permet par exemple de colorer l'aluminium. On sait en effet que l'aluminium brut se colore de façon naturelle et incontrôlée par oxydation, provoquant l'apparition de tâches ou de traces sur les surfaces de la pièce en aluminium considérée. Pour résoudre ce problème, il est possible d'oxyder une pièce en aluminium de manière artificielle, afin de rendre son aspect uniforme et esthétique. Cette technique d'oxydation contrôlée de l'aluminium est connue sous le nom d'anodisation ou d'éloxage. L'anodisation est un procédé de traitement de surface électrochimique de l'aluminium qui vise à créer une couche d'oxyde à la surface d'une pièce en aluminium. A cet effet, la pièce en aluminium est immergée dans un bain dans lequel est dispersé un électrolyte renfermant de l'acide sulfurique. En faisant circuler un courant continu dans ce bain, on parvient à former à la surface de la pièce en aluminium une couche d'oxyde poreuse dont l'épaisseur est typiquement de l'ordre de quelques dizaines de micromètres. Cette couche d'oxyde très dure protège la surface de la pièce en aluminium contre la corrosion et peut ensuite, de par sa porosité, être colorée en emprisonnant un colorant dans la matière.

Au British Muséum de Londres, on peut admirer la coupe de Lycurgue, du nom du mythique législateur de Sparte qu'elle représente. Confectionnée au IVème siècle av. J.-C. par des verriers romains, cette coupe paraît verte lorsqu'elle est éclairée de face, et rouge lorsqu'elle est éclairée par l'arrière. Ce dichroïsme est dû à la présence dans le verre de faibles proportions de nanoparticules d'or et d'argent qui donnent lieu à des phénomènes de surface de type plasmonique. Le phénomène plasmonique de surface s'observe lorsque tous les électrons libres d'un métal exposé à un même champ électromagnétique de longueur d'onde λ beaucoup plus grande que la taille des particules de métal oscillent collectivement et en phase. Des nanoparticules métalliques exposées à un rayonnement lumineux présentent ainsi des propriétés de diffusion de la lumière dues aux oscillations plasmoniques excitées. Ces propriétés dépendent de la forme des particules, de leur taille, de leur nature et du milieu dans lequel elles sont dispersées.

La production de couleurs sur des métaux en utilisant l'effet plasmonique est d'un grand intérêt en raison de sa durabilité comme en témoigne la coupe de Lycurgue, et de la possibilité d'éviter encres, peintures ou pigments. Une technique de coloration des métaux par exploitation des plasmons a été proposée par une équipe de chercheurs canadiens. Cette technique consiste à créer à la surface de pièces en or, en argent, en cuivre ou en aluminium des nanostructures contrôlées au moyen d'un faisceau laser. Pour atteindre ce résultat, les pièces métalliques ont été traitées au moyen de rafales d'impulsions laser produites par un laser émettant dans le proche infrarouge à une longueur d'onde de 1.064 µm. La durée d'une impulsion laser est de 10⁻¹² s et chaque rafale d'impulsions est séparée de la suivante par des intervalles de temps égaux. Pour permettre au faisceau laser de suivre toute l'image que l'on veut créer à la surface de la pièce métallique, le déplacement de ce faisceau laser est assuré par un jeu de miroirs asservis commandés par un ordinateur. Ces impulsions laser créent ainsi des nanoparticules à la surface de la pièce métallique traitée et permettent d'obtenir une gamme très complète de couleurs.

### Résumé de l'invention

La présente invention a pour but de proposer une nouvelle technique de coloration de métaux.

A cet effet, la présente invention concerne un procédé de coloration d'une pièce à traiter réalisée en métal, ce procédé comprenant l'étape qui consiste à implanter des ions mono- ou multichargés dans une couche superficielle de la pièce à traiter en dirigeant vers cette pièce à traiter un faisceau d'ions mono- ou multichargés produit par une source d'ions mono- ou multichargés, la pièce à traiter changeant de couleur sous l'effet de cette implantation ionique.

Selon des formes spéciales d'exécution de l'invention :
- la source d'ions mono- ou multichargés est une source d'ions ECR;
- la pièce à traiter est fixée sur une pièce support insensible au traitement d'implantation ionique ;
- la pièce support est une pièce en céramique ;
- la pièce support est une pièce d'habillage ;
- la pièce d'habillage est destinée à l'horlogerie ou à la bijouterie ;
- la pièce d'habillage est choisie dans le groupe formé par une carrure de montre, un fond de boîte de montre, une lunette de montre, un cadran de montre, un maillon de bracelet de montre ou de bijou, un pont ou une platine de mouvement de montre, des aiguilles de montre et une bague ;
- le métal dans lequel est réalisée la pièce à traiter est choisi dans le groupe des métaux précieux formé par l'or, l'argent, le platine, le palladium, le ruthénium, l'iridium et les alliages de ces métaux précieux ;
- la pièce à traiter est réalisée au moyen de cuivre, d'aluminium, de zirconium, de titane ou d'un alliage de ces métaux ;
- le matériau à ioniser est choisi dans le groupe formé par le carbone, l'azote, l'oxygène, l'hélium et l'argon ;
- les ions mono- ou multichargés sont accélérés sous des tensions comprises entre 12.5 kV et 47.5 kV, la puissance du faisceau d'ions est comprise entre 4 mA et 15 mA et la dose d'ions implantée est comprise entre 5.10¹⁵ ions.cm⁻² et 75.10¹⁶ ions.cm⁻² ;
- la pièce à traiter est placée dans une chambre à vide dans laquelle est injecté le faisceau d'ions mono- ou multichargés ;
- après le traitement d'implantation ionique, la pièce à traiter est soumise à un traitement thermique de recuit.

L'invention concerne également une pièce métallique colorée grâce au procédé de coloration selon l'invention.

Grâce à ces caractéristiques, la présente invention procure un procédé de coloration de pièces métalliques massives ou fixées par tout moyen approprié sur une pièce support. On s'est en effet rendu compte qu'en bombardant de manière appropriée une pièce métallique avec un faisceau d'ions, il était possible de modifier la couleur de cette pièce métallique de manière contrôlée et reproductible. Ce procédé est particulièrement intéressant dans le cas où les pièces métalliques sont fixées sur une pièce support. En effet, pour peu que la pièce support soit insensible au bombardement ionique, il est possible de modifier la couleur des pièces métalliques sans précautions particulières ; on évite notamment les opérations de masquage longues et fastidieuses. Le procédé selon l'invention trouve ainsi tout son intérêt notamment dans les domaines de l'horlogerie et de la bijouterie en permettant de colorer par exemple des inclusions métalliques comme des heures index fixées sur une pièce en céramique comme une lunette de montre. En outre, le procédé selon l'invention est aisé et rapide à mettre en œuvre et ne fait intervenir aucun produit polluant ou toxique.

### Brève description des figures

D'autres caractéristiques et avantages de la présente invention ressortiront plus clairement de la description détaillée qui suit d'un mode de mise en œuvre du procédé selon l'invention, cet exemple étant donné à titre purement illustratif et non limitatif seulement en liaison avec le dessin annexé sur lequel :
- la figure 1 est une représentation schématique d'une source d'ions du type à résonance cyclotron électronique ECR ;
- la figure 2 est une représentation schématique d'une installation d'implantation ionique pour la mise en œuvre du procédé selon l'invention, et
- les figures 3A et 3B illustrent schématiquement le changement de couleur de la pièce à traiter une fois qu'elle a été soumise au procédé d'implantation ionique.

### Description détaillée de l'invention

La présente invention procède de l'idée générale inventive qui consiste à bombarder une pièce métallique massive ou rapportée à la surface d'une pièce support au moyen d'un faisceau d'ions mono- ou multichargés dans le but de modifier la couleur de la pièce métallique ainsi bombardée. Grâce à ces caractéristiques, la présente invention procure un procédé de coloration de pièces métalliques qui ne fait pas appel à des produits toxiques ou polluants et qui est donc simple et rapide à mettre en œuvre. Par ailleurs, dans le cas où la pièce métallique est rapportée sur une pièce support, pour peu que le matériau dans lequel est réalisée la pièce support soit insensible au bombardement ionique, il est possible de modifier la couleur de la pièce métallique bombardée sans être obligé de procéder à des opérations de masquage longues et fastidieuses.

Pour la mise en œuvre du procédé selon l'invention, on peut avantageusement utiliser une source d'ions mono- ou multichargés du type à résonance cyclotron électronique. Egalement connue sous sa dénomination anglo-saxonne Electron Cyclotron Resonance ou ECR, une telle installation fait usage de la résonance cyclotronique des électrons pour créer un plasma. Un volume de gaz à basse pression est ionisé au moyen de micro-ondes injectées à une fréquence correspondant à la résonance cyclotron électronique définie par un champ magnétique appliqué à une région située à l'intérieur du volume de gaz à ioniser. Les micro-ondes chauffent les électrons libres présents dans le volume de gaz à ioniser. Ces électrons libres, sous l'effet de l'agitation thermique, vont entrer en collision avec les atomes ou les molécules de gaz et provoquer leur ionisation. Les ions produits correspondent au type de gaz utilisé. Ce gaz peut être pur ou composé. Il peut également s'agir d'une vapeur obtenue à partir d'un matériau solide ou liquide. La source d'ions ECR est en mesure de produire des ions monochargés, c'est-à-dire des ions dont le degré d'ionisation est égal à +1, ou bien des ions multichargés, c'est-à-dire des ions dont le degré d'ionisation est supérieur à +1. Le faisceau d'ions peut également correspondre à un mélange d'ions mono- et multichargés.

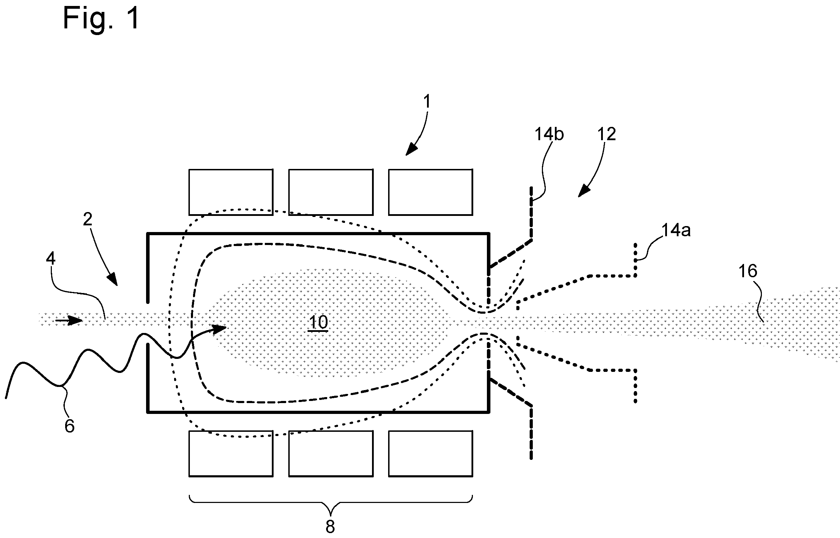

Une source d'ions du type à résonance cyclotron électronique ECR est schématiquement illustrée sur la figure 1 annexée à la présente demande de brevet. Désignée dans son ensemble par la référence numérique générale 1, cette source d'ions ECR comprend un étage d'injection 2 dans lequel on introduit un volume 4 d'un gaz à ioniser et une onde hyperfréquence 6, un étage de confinement magnétique 8 dans lequel est créé un plasma 10, et un étage d'extraction 12 qui permet d'extraire et d'accélérer les ions du plasma 10 au moyen d'une anode 14a et d'une cathode 14b entre lesquelles est appliquée une haute tension. Un faisceau d'ions 16 produit en sortie de la source d'ions ECR 1 vient frapper une surface 18 d'une pièce à traiter 20 et pénètre dans la surface de la pièce à traiter 20.

La pièce à traiter 20 est une pièce métallique. Le métal dans lequel est réalisée la pièce à traiter est préférentiellement mais non limitativement choisi dans le groupe des métaux précieux formé par l'or, l'argent, le platine, le palladium, le ruthénium, l'iridium et les alliages de ces métaux précieux. Selon une autre forme spéciale d'exécution de l'invention, la pièce à traiter peut être réalisée au moyen de cuivre, d'aluminium, de zirconium, de titane ou d'un alliage de ces métaux.

De préférence mais non exclusivement, le matériau à ioniser est choisi dans le groupe formé par le carbone, l'azote, l'oxygène, l'hélium et l'argon, et les ions mono- ou multichargés sont accélérés sous des tensions comprises entre 12.5 kV et 47.5 kV. La puissance du faisceau d'ions 16 est comprise entre 4 mA et 15 mA et la dose d'ions implantée est comprise entre 5.10¹⁵ ions.cm⁻² et 75.10¹⁶ ions.cm⁻². On interrompt le processus d'implantation ionique lorsque la couleur recherchée est observée.

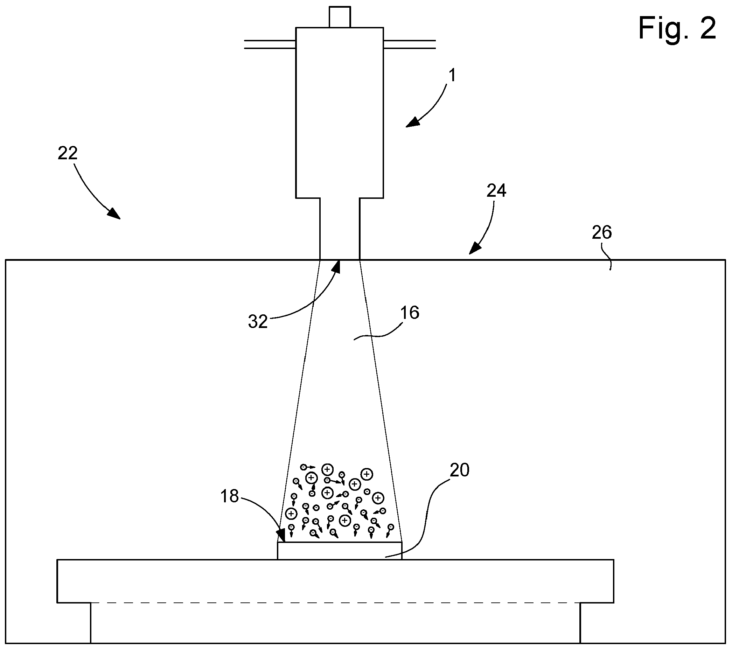

Une installation d'implantation ionique permettant la mise en œuvre du procédé selon l'invention est représentée schématiquement à la figure 2. Désignée dans son ensemble par la référence numérique générale 22, cette installation d'implantation ionique comprend une chambre à vide 24 dans une enceinte étanche 26 de laquelle est placée la pièce à traiter 20 qui est destinée à être soumise au procédé d'implantation ionique.

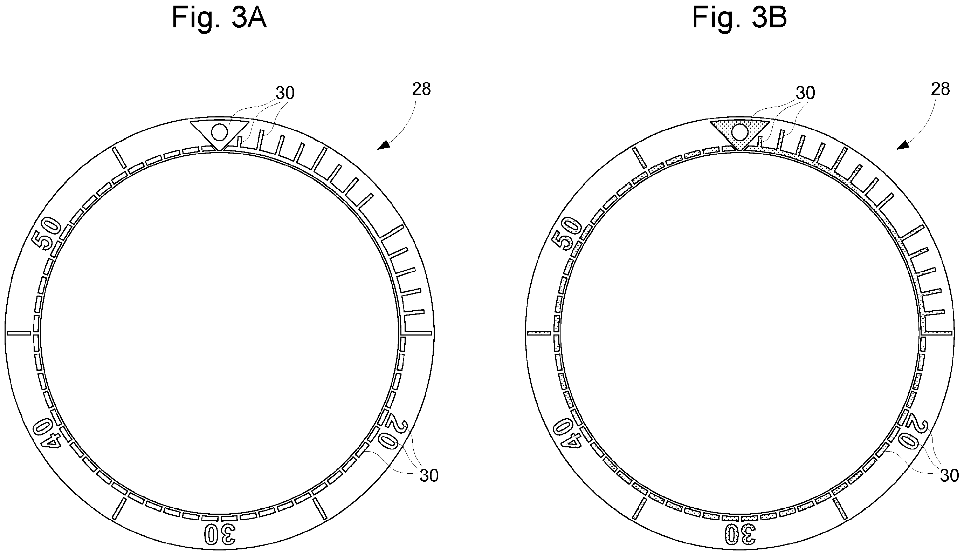

La pièce à traiter 20 peut être massive. Il peut également s'agir d'une pièce d'habillage, en particulier pour l'horlogerie ou la bijouterie, telle qu'une lunette 28 pour une montre. Dans un exemple particulier de réalisation, cette lunette 28 est réalisée en un matériau céramique et reçoit dans des creusures ménagées à sa surface des inserts métalliques 30. Ces inserts métalliques 30 dont on veut changer la couleur forment par exemple à la surface de la lunette 28 une succession de nombres et d'index qui peuvent varier par leurs formes et/ou leurs dimensions (voir figure 3A).

La source d'ions, ici la source d'ions ECR 1, est fixée de manière étanche sur l'enceinte étanche 26 de la chambre à vide 24, en regard d'une ouverture 32 ménagée dans cette enceinte étanche 26. Cette source d'ions ECR 1, d'un type identique à celle décrite ci-avant, est orientée de façon que le faisceau d'ions 16 mono- ou multichargés qu'elle produit se propage dans l'enceinte étanche 26 et vient frapper la surface de la pièce à traiter 20. Les ions mono- ou multichargés qui viennent frapper la pièce à traiter 20 pénètrent plus ou moins profondément dans la surface de cette pièce à traiter 20 et provoquent le changement de couleur de cette dernière.

On donne ci-après quelques exemples chiffrés de mise en œuvre du procédé selon l'invention appliqué à une lunette 28 en céramique avec des inserts métalliques 30.

Dans le cas où les inserts métalliques 30 sont réalisés en un alliage de zirconium et d'aluminium, le traitement de ces inserts métalliques 30 au moyen d'un faisceau d'ions azote d'une puissance de 7 mA accéléré sous une tension de 35 kV a permis de donner à ces inserts métalliques 30 une couleur bleue lorsque la dose d'implantation ionique était de 50.10¹⁶ ions.cm⁻².

Dans le cas où les inserts métalliques 30 sont réalisés en titane, le traitement de ces inserts métalliques 30 au moyen d'un faisceau d'ions azote d'une puissance de 6 mA accéléré sous une tension de 37.5 kV a permis de donner à ces inserts métalliques 30 une couleur or lorsque la dose d'implantation ionique était de 25.10¹⁶ ions.cm⁻².

Dans le cas où les inserts métalliques 30 sont réalisés en titane, le traitement de ces inserts métalliques 30 au moyen d'un faisceau d'ions azote d'une puissance de 6 mA accéléré sous une tension de 20.0 kV a permis de donner à ces inserts métalliques 30 une couleur bleue lorsque la dose d'implantation ionique était de 25.10¹⁶ ions.cm⁻².

Dans le cas où les inserts métalliques 30 sont réalisés en titane, le traitement de ces inserts métalliques 30 au moyen d'un faisceau d'ions oxygène d'une puissance de 4 mA accéléré sous une tension de 12.5 kV a permis de donner à ces inserts métalliques 30 une couleur violette lorsque la dose d'implantation ionique était de 25.10¹⁶ ions.cm⁻².

Les figures 3A et 3B illustrent schématiquement le changement de couleur de la pièce à traiter 20 une fois qu'elle a été soumise au procédé d'implantation ionique selon l'invention. Dans le cas d'une pièce d'habillage pour l'horlogerie telle que la lunette 28 en céramique (voir figure 3A), on observe après le traitement d'implantation ionique (voir figure 3B) un changement de couleur des inserts métalliques 30.

Il va de soi que la présente invention n'est pas limitée au mode de mise en œuvre qui vient d'être décrit et que diverses modifications et variantes simples peuvent être envisagées par l'homme du métier sans sortir du cadre de l'invention tel que défini par les revendications annexées. On notera en particulier que par ions mono- ou multichargés on entend des ions dont le degré d'ionisation est égal ou supérieur à +1. On notera aussi que le faisceau d'ions peut être composé d'ions présentant tous le même degré d'ionisation, ou peut résulter d'un mélange d'ions présentant des degrés d'ionisation différents. On note de même que dans le cas où l'on traite par exemple les inserts métalliques d'une lunette en céramique, aucune opération de masquage n'est nécessaire : toute la surface de la lunette peut être exposée au faisceau d'ions, sans que cela n'altère les propriétés mécaniques ou l'aspect du matériau céramique. Seule la couleur des inserts métalliques va changer. Pour rendre la couleur des inserts métalliques encore plus profonde, voire pour la changer, il est possible, après traitement d'implantation ionique, de soumettre la pièce à traiter, par exemple la lunette en céramique avec ses inserts métalliques, à un traitement thermique de recuit. Dans ce cas aussi, le traitement de recuit n'affectera pas les propriétés de la céramique.

### Nomenclature

1. Source d'ions ECR
2. Etage d'injection
4. Volume de gaz à ioniser
6. Onde hyperfréquence
8. Etage de confinement magnétique
10. Plasma
12. Etage d'extraction
14a. Anode
14b. Cathode
16. Faisceau d'ions
18. Surface
20. Pièce à traiter
22. Installation d'implantation ionique
24. Chambre à vide
26. Enceinte étanche
28. Lunette
30. Inclusions métalliques
32. Ouverture

## Revendications

1. Procédé de coloration d'une pièce à traiter (20) réalisée en métal, ce procédé comprenant l'étape qui consiste à implanter des ions mono- ou multichargés dans une couche superficielle de la pièce à traiter (20) en dirigeant vers cette pièce à traiter (20) un faisceau d'ions mono- ou multichargés produit par une source d'ions mono- ou multichargés, la pièce à traiter (20) changeant de couleur sous l'effet de cette implantation ionique.

2. Procédé de coloration selon la revendication 1, **caractérisé en ce que** la source d'ions mono- ou multichargés est une source d'ions ECR (1).

3. Procédé de coloration selon l'une des revendications 1 et 2, **caractérisé en ce que** la pièce à traiter (20) est fixée sur une pièce support insensible au traitement d'implantation ionique.

4. Procédé de coloration selon la revendication 3, **caractérisé en ce que** la pièce support est une pièce en céramique.

5. Procédé de coloration selon la revendication 4, **caractérisé en ce que** la pièce support est une pièce d'habillage.

6. Procédé de coloration selon la revendication 5, **caractérisé en ce que** la pièce d'habillage est destinée à l'horlogerie ou à la bijouterie.

7. Procédé de coloration selon la revendication 6, **caractérisé en ce que** la pièce d'habillage est choisie dans le groupe formé par une carrure de montre, un fond de boîte de montre, une lunette de montre, un cadran de montre, un maillon de bracelet de montre ou de bijou, un pont ou une platine de mouvement de montre, des aiguilles de montre et une bague.

8. Procédé de coloration selon l'une des revendications 1 à 7, **caractérisé en ce que** le métal dans lequel est réalisée la pièce à traiter (20) est choisi dans le groupe des métaux précieux formé par l'or, l'argent, le platine, le palladium, le ruthénium, l'iridium et les alliages de ces métaux précieux.

9. Procédé de coloration selon l'une des revendications 1 à 7, **caractérisé en ce que** la pièce à traiter (20) est réalisée au moyen de cuivre, d'aluminium, de zirconium, de titane ou d'un alliage de ces métaux.

10. Procédé de coloration selon l'une des revendications 1 à 9, **caractérisé en ce que** le matériau à ioniser est choisi dans le groupe formé par le carbone, l'azote, l'oxygène, l'hélium et l'argon.

11. Procédé de coloration selon la revendication 10, **caractérisé en ce que** les ions mono- ou multichargés sont accélérés sous des tensions comprises entre 12.5 kV et 47.5 kV, la puissance du faisceau d'ions est comprise entre 4 mA et 15 mA et la dose d'ions implantée est comprise entre 5.10¹⁵ ions.cm⁻² et 75.10¹⁶ ions.cm⁻² .

12. Procédé de coloration selon l'une des revendications 1 à 11, **caractérisé en ce que** la pièce à traiter (20) est placée dans une chambre à vide (24) dans laquelle est injecté le faisceau d'ions (16) mono- ou multichargés.

13. Procédé de coloration selon la revendication 12, **caractérisé en ce que**, après le traitement d'implantation ionique, la pièce à traiter (20) est soumise à un traitement thermique de recuit.

14. Pièce à traiter réalisée en métal et colorée au moyen du procédé de coloration selon l'une des revendications 1 à 13.
